Europäisches Patentamt

(19) European Patent Office

Office européen des brevets

(11) Publication number: **0 037 261**

**B1**

(12) **EUROPEAN PATENT SPECIFICATION**

(45) Date of publication of patent specification: **16.01.85**

(21) Application number: **81301326.5**

(22) Date of filing: **27.03.81**

(51) Int. Cl.⁴: **H 01 L 21/268,** H 01 L 21/263, H 01 L 21/225 // H01L29/78

(54) **A method of manufacturing a semiconductor device, and a device, for example a BOMIS FET, so manufactured.**

(30) Priority: **27.03.80 JP 39288/80**

(43) Date of publication of application:
**07.10.81 Bulletin 81/40**

(45) Publication of the grant of the patent:
**16.01.85 Bulletin 85/03**

(84) Designated Contracting States:
**DE FR GB NL**

(56) References cited:
**WO-A-80/00510**
**US-A-4 147 563**

**IEEE TRANSACTIONS ON ELECTRON DEVICES, volume ED-27, no. 1, January 1980 NEW YORK (US) T.I. KAMINS et al.: "A monolithic integrated circuit fabricated in laser-annealed polysilicon", pages 290-293**

(73) Proprietor: **FUJITSU LIMITED**
**1015, Kamikodanaka Nakahara-ku**
**Kawasaki-shi Kanagawa 211 (JP)**

(72) Inventor: **Mori, Haruhisa**
**No. 2612-27-2-302, Tokaichibamachi Midori-ku Yokohama-shi Kanagawa, 227 (JP)**
Inventor: **Ogawa, Tsutomu**
**No. 1-21-8, Honkomagome Bunkyo-ku Tokyo, 113 (JP)**
Inventor: **Matsumoto, Takashi**
**No. 1-15-1003, Kawara-cho Saiwai-ku Kawasaki-shi Kanagawa, 210 (JP)**

(74) Representative: **Sunderland, James Harry et al HASELTINE LAKE & CO Hazlitt House 28 Southampton Buildings Chancery Lane London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to a method of manufacturing a semiconductor device, and a device, for example a BOMIS FET, so manufactured.

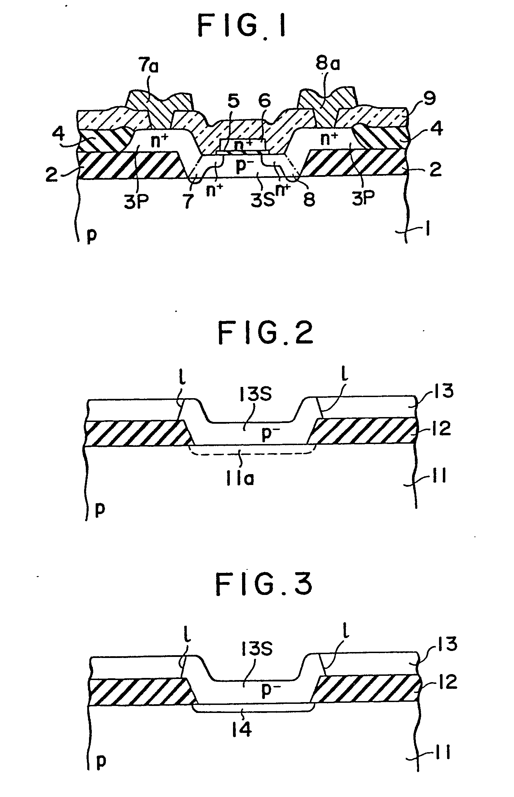

A known BOMIS FET (a Buried Oxide MIS field effect transistor) has a structure as illustrated in enlarged sectional view in Figure 1 of the accompanying drawings.

In Figure 1, 1 is a p type low resistance silicon semiconductor substrate having a resistivity $\rho_b$ of, for example, 1 to 2 $\Omega$. cm; 2 is a silicon dioxide ($SiO_2$) film; 3S is a single crystalline silicon semiconductor layer; 3P is a polycrystalline silicon semiconductor layer; 4 is another silicon dioxide film; 5 is a gate oxide film; 6 is a silicon gate electrode; 7 is a source region; 8 is a drain region; 9 is a phosphosilicate glass film 7a is a source electrode; and 8a is a drain electrode.

Such a known semiconductor device has been manufactured by a method such as that described below.

The manufacture starts with the formation of a silicon dioxide film 2 to a thickness of about 1 $\mu$m on a p type low resistance (for example, resistivity $\rho_b \approx 1$ to 2 $\Omega$. cm) silicon semiconductor substrate 1 through the use of a thermal oxidation method.

The silicon dioxide film 2 is subjected to patterning by ordinary photolithography to form therein a window, through which is exposed a portion of the surface of the single crystal silicon substrate 1.

Then, a silicon semiconductor layer is formed by an epitaxial growth method so as to cover the silicon dioxide layer 2 and the exposed substrate surface. In this case, the silicon semiconductor layer is composed of a single crystalline silicon semiconductor layer 3S formed on the exposed surface of the single crystal substrate 1 and a polycrystalline silicon semiconductor layer 3P formed on the silicon dioxide film 2. During the growth of the silicon semiconductor layer, impurity in the substrate 1 is caused to diffuse out therefrom into the single crystalline silicon semiconductor layer 3S to make it p⁻ type. The silicon semiconductor layers 3S and 3P are respectively formed about 1 $\mu$m thick.

Following this, the polycrystalline silicon semiconductor layer 3P is partly oxidised to form a silicon dioxide film 4 of about 1 $\mu$m in thickness, by means of selective thermal oxidation using for example, a silicon nitride ($Si_3N_4$) film as a mask. In this case, the portion of the polycrystalline silicon semiconductor layer 3P to be selectively oxidised is usually etched to make it shallower, prior to thermal oxidation, so that the surfaces of the silicon dioxide film 4 to be formed and the polycrystalline silicon semiconductor layer 3P can be made substantially flush with one another.

After removing the silicon nitride film mask, a thin silicon dioxide film is formed by thermal oxidation so as to extend over the silicon semiconductor layers 3S and 3P, and a polycrystalline silicon layer is formed by chemical vapour deposition on the abovesaid thin silicon dioxide film.

Thereafter, the abovesaid polycrystalline silicon layer and the thin silicon dioxide film are subjected to patterning by ordinary photolithography, forming a gate oxide film 5 and a silicon gate electrode 6.

After this, for example, arsenic ions (As⁺) are injected by ion implantation to form an n⁺ type source region 7 and an n⁺ type drain region 8, at the same time making the silicon gate electrode 6 n⁺ type. The sheet resistance $\rho$s of each of the so formed n⁺ type portions is 10 to 20 $\Omega/\square$.

Next, a phosphosilicate glass film 9 is formed to a thickness of 0.8 $\mu$m or more by chemical vapour deposition and then the film 9 is patterned by ordinary photolithography to provide windows for contact with electrodes.

Thereafter, an electrode metal film is formed and then patterned to form a source electrode and wire 7a and a drain electrode and wire 8a, and further, an insulating film (not shown) is formed which serves as a surface protecting film; thus, a device is completed.

The above manufacturing process employs, for imparting p⁻ conductivity type to the single crystalline silicon semiconductor layer 3S, the out-diffusion of an impurity from the substrate 1 during epitaxial growth. This method is desirable from the viewpoint of reducing the number of manufacturing steps involved on the one hand but has demerits on the other hand. Namely, since it is necessary to perform the out-diffusion of an impurity simultaneously with the epitaxial growth of the silicon semiconductor layer, the step therefor requires a high temperature and much time. Accordingly, this step can greatly affect the manufacturing cost of the device and can cause warping of the substrate and the occurrence of crystal defect.

With present semiconductor technology, it should be possible to impart a suitable impurity concentration to the single crystalline silicon semiconductor layer 3S by doping it with an impurity during the growth of the aforesaid silicon semiconductor layer. With such a method, however, impurity concentration is difficult to control and, in obtaining a proper impurity concentration, there is a problem in terms of reproducibility. Further, it should also be possible to impart an impurity by ion implantation after growth of the silicon semiconductor layer but, in this case, too, high-temperature and time-consuming annealing is required and such annealing is an obstacle to the fabrication of a device with a high integration density.

WO—A—80/00510 discloses a method of providing a poly or monocrystalline layer of a semiconductor material on a substrate of a semiconductor device by depositing the semiconductor material in amorphous form onto the substrate, vaporised for example, and by means of a thermal treatment by optical radiation applied onto the material, transforming the material into a poly or monocrystalline layer. It is also possible to deposit said amorphous semiconductor material in openings of an insulating layer provided on the semiconductor substrate and transform the amorphous material into monocrystalline material.

US—A—4 147 563 discloses laser diffusion of a selected dopant into a silicon body by means of laser pulses of selected wavelength, energy density and duration. Initially the dopant is deposited on the silicon body as a superficial layer. The laser pulses are used then to produce melting of the layer and of the contiguous portion of said silicon body and to diffuse dopant into said portion.

According to the present invention there is provided a method of manufacturing a semiconductor device, in which an insulating layer having a window therein is formed on a semiconductor substrate, and a polycrystalline or amorphous semiconductor layer is formed on the insulating layer and on the substrate surface exposed in the window, and then a portion of the semiconductor layer corresponding to the window and a portion of the underlying substrate are melted by irradiation with an energy beam, so that impurity contained in the substrate underneath said window is rapidly out-diffused into the semiconductor layer portion and the melted semiconductor layer portion is rendered single-crystalline.

According to the present invention there is also provided a device made by a method according to the invention. The device may be a BOMIS field effect transistor. A complementary MIS field effect transistor can be provided as can an enhancement mode field effect transistor or a depletion mode field effect transistor.

An embodiment of the present invention can provide a semiconductor device manufacturing method in which a semiconductor layer formed on a semiconductor substrate containing an impurity is irradiated by an energy beam to melt a portion of the semiconductor substrate as well as the semiconductor layer, whereby the impurity in the semiconductor substrate is diffused into the semiconductor layer. This avoids the high-temperature, time-consuming thermal diffusion step of the prior art and can provide a semiconductor device of excellent characteristics.

Reference is made, by way of example, to the accompanying drawings, in which:—

Figure 1 is an enlarged sectional view showing principal parts of a prior art semiconductor device,

Figure 2 is an enlarged sectional view illustrating principal parts of a semiconductor device at an important step in its manufacture, for explanation of an embodiment of the present invention, Figure 3 is an enlarged sectional view illustrating principal parts of a semiconductor device at an important step in its manufacture, for explanation of another embodiment of the present invention,

Figure 4 is an enlarged sectional view illustrating principal parts of a semiconductor device at an important step in its manufacture, for explanation of still another embodiment of the present invention,

Figure 5 is an enlarged sectional view showing principal parts of the semiconductor device of Figure 4 at a manufacturing stage after the step of Figure 4, and

Figure 6 is a graph illustrating a relationship between laser energy density and melt depth.

Referring first to Figure 2, a method embodying the present invention will be described in detail.

At first, a silicon dioxide film 12 about 1 $\mu$m thick is formed by thermal oxidation on the top surface of a p type silicon semiconductor substrate 11 and the silicon dioxide film 12 is subjected to patterning to form therein a window, as in the prior art explained above.

Next, a silicon semiconductor layer 13 is formed, for example, approximately 5000 Å thick, on the semiconductor substrate 11 by chemical vapour deposition using monosilane ($SiH_4$) as a silicon source and decomposing the monosilane at 400 to 900°C. When grown at such low temperatures, the silicon formed is polycrystalline. It is alternatively possible to form an amorphous silicon layer by evaporation, as required.

Then, the silicon semiconductor layer 13 overlying the window in the silicon dioxide film 12, and the underlying semiconductor substrate 11, are made partly molten by irradiation with a photon beam, such as a laser beam, and then solidified. The irradiation may be carried out with an electron beam or ion beam instead of the laser beam. When the molten portion of the polycrystalline silicon semiconductor layer 13 solidifies, epitaxial growth takes place in that portion under the influence of the substrate 11, which is singlecrystalline, resulting in the molten portion of layer 13 becoming single-crystalline. Namely, the portion of layer 13 which will ultimately form a part of a channel, a source region and a drain region becomes a single crystalline silicon semiconductor portion, which is identified by 13S in Figure 2. The boundary between the single crystalline semiconductor portion 13S and the polycrystalline silicon semiconductor portion in layer 13 is indicated by solid lines 1. Reference numeral 11a indicates that portion of the semiconductor substrate 11 which was melted, to a shallow depth, by the laser beam. By the way, when a part of the semiconductor substrate 11 is thus made molten by the laser beam, the p type impurity contained in that part rapidly diffuses into the single crystal silicon semiconductor portion 13S to make it p⁻ type uniformly. Incidentally, the diffusion speed of an impurity in a liquid form medium is greater by about several orders of magnitude than the speed of ordinary out-diffusion. For example, the diffusion coefficient of arsenic (As) in liquid phase silicon is $\sim 10^{-4}$ cm²/sec, whereas in solid phase silicon it is about 2 to $5 \times 10^{-13}$ cm²/sec at 1200°C and 2 to $3 \times 10^{-14}$ cm²/sec at 1100°C.

The step of laser beam irradiation is followed by the same manufacturing steps as in the prior art, thus obtaining a BOMIS field effect transistor.

In the above embodiment, it is very easy to control the impurity concentration of the single crystalline silicon semiconductor portion 13S. That is, the amount of impurity diffused can be controlled by a suitable selection of laser energy density depending on the depth to which the semiconductor substrate 11 is made molten. For instance, in a case where the impurity concentration of the semiconductor substrate 11 was $1 \times 10^{16}$ cm⁻³ and the single crystalline silicon semiconductor portion 13S was 5000 Å thick, the impurity concentration of the single crystalline silicon semiconductor portion 13S could be made $1.7 \times 10^{15}$ cm⁻³ and $2.9 \times 10^{15}$ cm⁻³ by melting the semiconductor substrate 11 to depths of 6000 Å and 7000 Å, respectively.

According to the present embodiment of the invention, the impurity concentration profile can be made the reverse of that arising in an ordinary case, that is, the impurity concentration of a semiconductor can be made to increase inwardly. This is effective for preventing a punch through phenomenon between the source and drain of a MOS field effect transistor; accordingly, individual elements can be miniaturized, facilitating the fabrication of devices with high integration density.

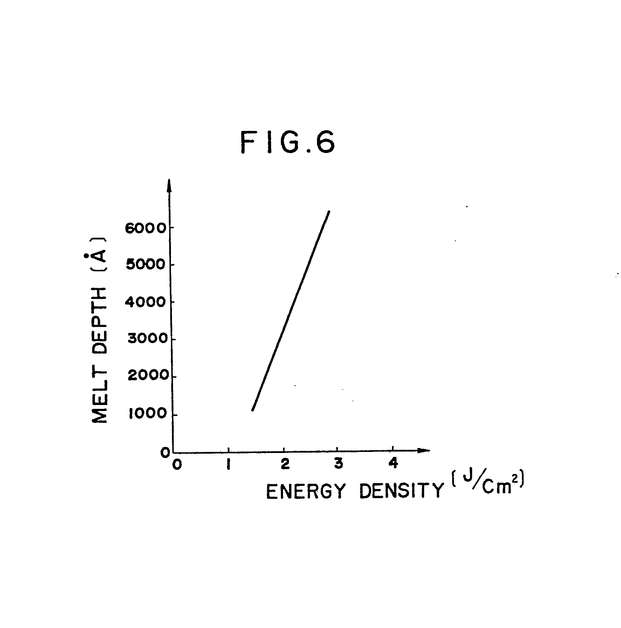

The relationship between energy density and melt depth in a case in which silicon is melted by a laser beam of a Ruby laser is as shown in Figure 6. As will be seen from the graph, an energy density of $\sim 2.5$ J/cm² is needed for melting the silicon to a depth of, for example, 5000 Å and $\sim 2.8$ J/cm² is required for melting to a depth of 6000 Å. Further, the accuracy of impurity concentration obtainable by 5 to 10 irradiations with laser beam pulses of a Ruby laser having an energy density of, for example, 2.5 J/cm² is $\pm 10\%$ or so.

The impurity concentration of the single-crystalline silicon semiconductor portion 13S can be controlled also by another means, which will be described below with reference to Figure 3.

Figure 3 is a schematic representation, similar to Figure 2, illustrating another embodiment of the present invention. This embodiment is identical with the embodiment of Figure 2 insofar as the step of forming the silicon dioxide film 12 on the surface of the substrate 11 and then forming a window in the silicon dioxide film 12 is concerned. Thereafter, in the Figure 3 embodiment, however, boron ions (B⁺) are injected as by ion implantation into the exposed portion of the substrate 11 to form therein a p type region 14 of a predetermined impurity concentration and then the silicon semiconductor layer 13 is grown. In the case of annealing by laser beam irradiation, the melt depth of the semiconductor substrate 11 can be held constant by maintaining the laser energy density at a fixed value. Consequently, the impurity concentration of the singlecrystalline silicon semiconductor portion 13S can be controlled in dependence upon the impurity concentration of the p type region 14 formed by ion implantation through the window in the silicon dioxide film 12.

Incidentally, the embodiment of Figure 3 can provide a structure which is unobtainable with the embodiment of Figure 2. That is, by forming the polycrystalline silicon layer and performing the laser annealing after forming respective impurity regions of different impurity types by selectively injecting n type or p type impurity through many windows formed in the silicon dioxide film 12, a p type and an n type singlecrystalline silicon semiconductor portion 13S can be obtained; accordingly, a complementary MIS field effect transistor can be constituted with ease.

Moreover, by injecting impurity of the same conductivity type through the windows in the silicon dioxide film 12 whilst selectively changing the quantity of impurity injected for each window, the impurity concentration of the singlecrystalline silicon semiconductor portion 13S can be made to differ for different windows. Accordingly, it is possible to produce MIS field effect transistors having threshold voltages Vth which differ in accordance with the impurity concentrations, and an enhancement mode and a depletion mode MIS field effect transistor can be formed very easily.

With the embodiment described above in connection with Figure 3, in the case where the impurity dose is $1 \times 10^{12}$ cm⁻² and the singlecrystalline silicon semiconductor portion 13S is 4000 Å thick and the semiconductor substrate 11 is molten to a depth of 1000 Å, an impurity concentration of $2 \times 10^{16}$ cm⁻³ or so can be obtained. In this case, if the impurity dose is $2.5 \times 10^{11}$ cm⁻², an impurity concentration of $\sim 5 \times 10^{15}$ cm⁻³ or so can be obtained.

In the embodiments of Figures 2 and 3, Ruby laser is used but a CW laser may alternatively be employed. In such a case, to meet various conditions arising in different embodiments, with an Argon laser adjusted to have a beam diameter of $\sim 100$ μm and an output of about 10 W or so; by scanning at a speed of 25 cm/sec, it is possible to obtain the same results as those obtainable with a Ruby laser.

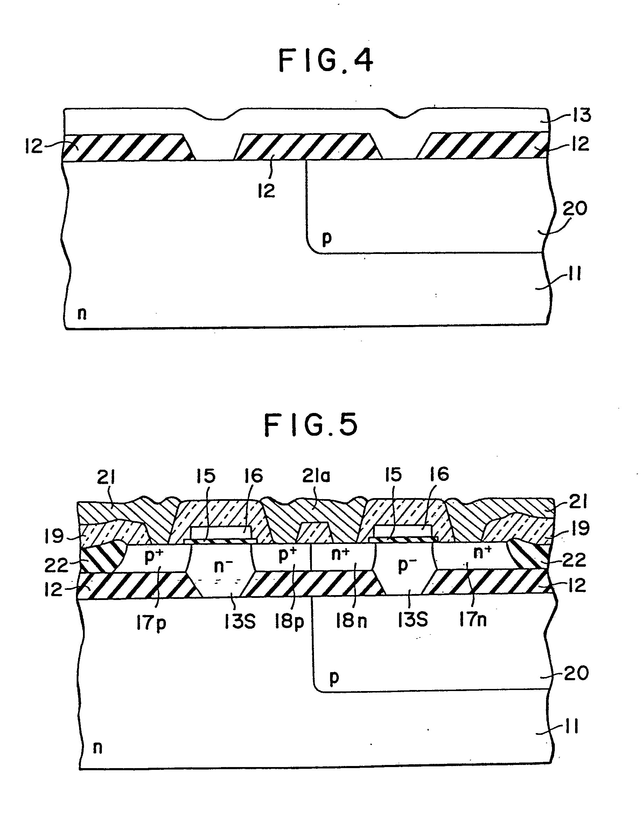

A description will be given, with reference to Figures 4 and 5, of other embodiments of the present invention.

First, as shown in Figure 4, a p type well region 20 is formed by an ordinary method in an n type silicon semiconductor substrate 11 and then a silicon dioxide film 12 is formed by thermal oxidation on the surface of the semiconductor substrate 11. The silicon dioxide film 12 is selectively removed by ordinary photolithography to form therein windows. Thereafter, by properly using the method of manufacturing a MIS field effect transistor as described above, there are formed a p channel type MIS field effect transistor on the semiconductor layer 13 overlying the n type silicon semiconductor substrate 11 and an n channel type MIS field effect transistor on the semiconductor layer 13 overlying the p type well region, as shown in Figure 5, thus constituting a complementary MIS field effect transistor. In this complementary MIS field effect transistor, a back gate bias can easily be applied via the p type well region 20 to that p⁻ type region of the singlecrystalline silicon semiconductor portion 13S which serves as channel region. The device of Figure 5 has a complementary MIS field effect transistor structure which forms an inverter circuit. A field oxide film 22, a gate oxide film 15, a silicon gate electrode 16, an $n^+$ type source region 17n, an $n^+$ type drain region 18n, a $p^+$ type source region 17p, a $p^+$ type drain region 18p, a phosphosilicate glass film 19, an electrode-wire 21, and an electrode wire 21a, are formed in the same manner as in the prior art.

As will be appreciated from the above, according to an embodiment of the present invention, since the polycrystalline silicon semiconductor layer which will ultimately serve as an active region is grown at a low temperature and in a short time as compared with a case in which epitaxial growth is used, defects and contamination arising through thermal strain are reduced, by which the yield of fabrication of devices and their reliability are increased. Further, when melting the polycrystalline silicon layer by laser irradiation, since the diffusion coefficient of an impurity in the liquid phase is very large, there can be obtained an impurity distribution uniform in the depthwise direction, whereby impurity regions are formed in such a manner as that called self alignment. Moreover, since the device region is made singlecrystalline by laser annealing, it has few defects and a high carrier mobility, permitting high speed operation and high reliability of the device.

A semiconductor device made by a method embodying this invention, in which an insulating layer having a window therein is formed on a semiconductor substrate, a semiconductor layer is formed on the insulating layer and a semiconductor element is formed on the singlecrystalline semiconductor layer, has the advantages of high-speed operation and low power consumption. A conventional manufacturing method involves a high-temperature, time-consuming step by which the semiconductor layer for forming thereon the semiconductor element is formed so as to have a proper impurity concentration. In a method embodying the present invention, however, a portion of the polycrystalline or amorphous semiconductor layer and a portion of the underlying substrate are made molten by annealing with an energy beam, for example a laser beam, whereby impurity contained in the substrate is diffused into the semiconductor layer. Accordingly, no high-temperature, time-consuming step is involved in a method embodying the present invention, permitting the production of a semiconductor device of excellent characteristics.

**Claims**

1. A method of manufacturing a semiconductor device, in which an insulating layer (12) having a window therein is formed on a semiconductor substrate (11), and a polycrystalline or amorphous semiconductor layer (13) is formed on the insulating layer and on the substrate surface exposed in the window, and then a portion of the semiconductor layer corresponding to the window and a portion of the underlying substrate are melted by irradiation with an energy beam, so that impurity contained in the substrate underneath said window is rapidly out-diffused into the semiconductor layer portion (13S) and the melted semiconductor layer portion (13S) is rendered singlecrystalline.

2. A method as claimed in claim 1, wherein the semiconductor layer (13) is a silicon semiconductor layer.

3. A method as claimed in claim 1 or 2, wherein the impurity concentration of the melted semiconductor layer portion (13S) is controlled by selecting the melt depth of the substrate (11).

4. A method as claimed in claim 1, 2 or 3, wherein an impurity is introduced, before the melt, into the portion of the substrate (11) corresponding to the window in the insulating layer (12).

5. A method as claimed in any preceding claim, wherein the energy beam is either a photon beam, an electron beam or an ion beam.

6. A method as claimed in claim 5, wherein the energy beam is a laser beam.

7. A semiconductor device made by a method as claimed in any preceding claim, being a BOMIS field effect transistor, a complementary MIS field effect transistor, an enhancement mode field effect transistor or a depletion mode field effect transistor, or an invertor circuit.

8. A semiconductor device as claimed in claim 7, wherein the impurity concentration of the device increases inwardly of the device in a channel region of the device, or is uniform.

**Patentansprüche**

1. Verfahren zur Herstellung einer Halbleiteranordnung, bei welchem eine Isolierschicht (12), die ein Fenster enthält, auf einem Halbleitersubstrat (11) gebildet wird, und eine polykristalline oder amorphe Halbleiterschicht (13) auf der Isolierschicht und auf der Substratoberfläche, die in dem Fenster exponiert ist, gebildet wird und dann ein Abschnitt der Halbleiterschicht, der dem Fenster entspricht, und ein Abschnitt des darunter liegenden Substrats durch Bestrahlung mit einem Energiestrahl geschmolzen werden, so daß eine Verunreinigung, die in dem Substrat unter dem geannten Fenster enthalten ist, schnell in den Halbleiterschichtabschnitt (13S) raus-diffundiert wird und der geschmolzene Halbleiterschichtabschnitt (13S) einkristallin gemacht wird.

2. Verfahren nach Anspruch 1, bei welchem die Halbleiterschicht (13) eine Siliziumhalbleiterschicht ist.

3. Verfahren nach Anspruch 1 oder 2, bei welchem die Verunreinigungskonzentration des geschmolzenen Halbleiterschichtabschnitts (13S) durch Auswahl der Schmelztiefe des Substrats (11) gesteuert wird.

4. Verfahren nach Anspruch 1, 2 oder 3, bei welchem vor der Schmelze eine Verunreinigung in den Abschnitt des Substrats (11) eingeführt wird, der dem Fenster in der Isolierschicht (12) entspricht.

5. Verfahren nach einem der vorhergehenden Ansprüche, bei welchem der Energiestrahl entweder ein Photonenstrahl, ein Elektronenstrahl oder ein Ionenstrahl ist.

6. Verfahren nach Anspruch 5, bei welchem der Energiestrahl ein Laserstrahl ist.

7. Halbleiteranordnung, hergestellt nach einem Verfahren nach einem der vorhergehenden Ansprüche, die ein BOMIS-Feldeffekttransistor, ein komplementärer MIS-Feldeffekttransistor, ein Feldeffekttransistor vom Anreicherungstyp oder ein Feldeffekttransistor vom Verarmungstyp oder eine Inverterschaltung ist.

8. Halbleiteranordnung nach Anspruch 7, bei welcher die Verunreinigungskonzentration der Anordnung zum Inneren der Anordnung hin in einen Kanalbereich der Anordnung hin anwächst oder gleichförmig ist.

**Revendications**

1. Procédé de fabrication d'un dispositif semiconducteur, dans lequel on forme une couche isolante (12) comportant une fenêtre sur un substrat semiconducteur (11), et on forme une couche semiconductrice (13) polycristalline ou amorphe sur la couche isolante et sur la surface du substrat qui est exposée par la fenêtre, puis on fait fondre une partie de la couche semiconductrice correspondant à la fenêtre et une partie du substrat sous-jacent par irradiation au moyen d'un faisceau énergétique, si bien que les impuretés contenues dans le substrat au-dessous de ladite fenêtre diffusent rapidement dans la partie (13S) de la couche semiconductrice et que la partie de couche semiconductrice fondue (13S) est rendue monocristalline.

2. Procédé selon la revendication 1, où la couche semiconductrice (13) est une couche semiconductrice de silicium.

3. Procédé selon la revendication 1 ou 2, où on ajuste la concentration en impuretés de la partie de couche semiconductrice fondue (13S) en choisissant la profondeur de fusion du substrat (11).

4. Procédé selon la revendication 1, 2 ou 3, où on introduit des impuretés, avant la fusion, dans la partie du substrat (11) correspondant à la fenêtre formée dans la couche isolante (12).

5. Procédé selon l'une quelconque des revendications précédentes, où le faisceau énergétique est un faisceau de photons, un faisceau d'électrons ou un faisceau d'ions.

6. Procédé selon la revendication 5, où le faisceau énergétique est un faisceau laser.

7. Dispositif semiconducteur fabriqué par un procédé selon l'une quelconque des revendications précédentes, qui est un transistor à effet de champ métal-isolant-semiconducteur à oxyde enterré, un transistor à effet de champ métal-isolant-semiconducteur complémentaire, un transistor à effet de champ de mode enrichissement ou un transistor à effet de champ de mode appauvrissement, ou un circuit inverseur.

8. Dispositif semiconducteur selon la revendication 7, où la concentration en impuretés du dispositif augmente vers l'intérieur du dispositif dans une région de canal du dispositif, ou bien est uniforme.

# FIG. 1

# FIG. 2

# FIG. 3

1

## F I G. 4

## F I G. 5

# FIG.6